# EUROPEAN PATENT APPLICATION

(11) **EP 4 369 420 A1**
(43) Date of publication of application: **15.05.2024**
(21) Application number: 22206119.4
(22) Date of filing: 08.11.2022
(51) Int. Cl.: H01L 31/048, H01L 31/18, H02S 30/20

(54) **PV ROLL AND METHOD OF MANUFACTURING A PV ROLL**

(71) Applicant: Sono Motors GmbH, 80935 München (DE)
(72) Inventor: CALCABRINI, Andres, 80935 Munich (DE); GIRI, Priyanka, 80935 Munich (DE); SHABANI, Amin, 80935 Munich (DE)
(74) Representative: Qip Patentanwälte Dr. Kuehn & Partner mbB

(57) **Abstract**

A method for producing a photovoltaic label (1) is described. The method comprises: providing a sub-stack (3) including a first lamination foil (7), a second lamination foil (9) and a solar cell arrangement (11) comprising multiple wafer-based solar cells (13), the solar cell arrangement (11) being interposed between the first and second lamination foils (7, 9), providing an elongate flexible carrier sheet (5) having a length of at least 2 m,
forming an overall-stack (15) by attaching the sub-stack (3) to the carrier sheet (5), and bending the overall-stack (15) into a roll configuration (29).

## Description

### FIELD OF THE INVENTION

The present invention relates to a method for producing a large photovoltaic label which may then be used for producing one or more photovoltaic panels. For example, the photovoltaic label may be used for producing a photovoltaic panel in a form of a vehicle body panel into which solar cells are integrated. Furthermore, the invention relates to a large photovoltaic label which may optionally be produced with the method described herein.

### TECHNICAL BACKGROUND

In the following, the term "photovoltaic" may be abbreviated by "PV". PV cells may also be referred to as solar cells.

Furthermore, the term "vehicle body panel" may refer to a panel which may be included in and/or attached to a body of any kind of vehicle such as cars, trucks, buses, mobile homes, trains, ships, airplanes, etc. For example, a vehicle body panel may form a cargo box of a truck or reefer.

Conventionally, most commercially available PV panels are typically produced by providing planar, rigid, wafer-based solar cells and then laminating these solar cells between a front side glass sheet and a rear side support structure such as another glass sheet or a metal sheet. Therein, the solar cells are interposed between thin lamination foils serving for both, tightly encapsulating the solar cells and mechanically interconnecting the stack including the front and rear side sheets with the interposed solar cell arrangement. All solar cells to be comprised in the PV panel are generally electrically interconnected with each other before being interposed and laminated with the lamination foils, such that an electrical connection to the solar cells comprised in the final PV panel may be established via a single junction box (or in some cases very few junction boxes, typically less than four junction boxes). Such PV panels are also referred to as PV modules and have typically a planar structure with the predefined standard size. Typically, such standard size is smaller than 1 m² in order to, inter-alia, enable simple handling of the PV modules such as manual handling by a single technician. These PV panels are well suited for installation, inter alia, on buildings or in solar farms.

Approaches have been presented in which PV cells are provided at a body of a vehicle for generating electricity to be supplied to the vehicle. Such electricity may be used for example for charging batteries of an electric car or for supplying electrical energy to power consuming assemblies such as for example a refrigeration unit.

In an approach for manufacturing PV modules, it has been proposed by the present applicant in an earlier patent application WO 2020/187792 A1 to integrate a solar cell arrangement into a moulded layer formed by injection moulding. Therein, the solar cell arrangement is interposed between polymeric foils, thereby forming a so-called photovoltaic label which may be securely handled and in which the solar cells are for example protected against excessive mechanical stress during an injection moulding procedure.

Another approach for a car body panel comprising an integrated solar cell arrangement has been proposed by the present applicant in an earlier patent application WO/2022/122507.

Furthermore, the present applicant presented in an earlier patent application EP 22 168 975 a concept for manufacturing PV panels with a roll-to-roll technique and in another earlier patent application EP 22 181 060 a concept for a PV sandwich panel which may be used e.g. in cargo boxes of reefers.

In all these approaches and concepts, a flexible PV label including rigid wafer-based solar cells enclosed between polymer layers is used for fabricating a PV panel, wherein a support structure stabilizes the PV label. Features and characteristics of such approaches and concepts may also apply to the PV label and the production method described herein and the content of the earlier patent applications shall be incorporated in its entirety herein by reference.

### SUMMARY OF THE INVENTION AND OF EMBODIMENTS

It may be an object to provide a method for producing a PV label which may be produced and subsequently handled during PV panel production in a simple, reliable and cost efficient manner. Furthermore, it may be an object to provide a PV label having such characteristics.

Such objects may be met with the subject-matter of the independent claims. Advantageous embodiments are defined in the dependent claims and described in the following specification and visualised in the associated figures.

According to a first aspect of the present invention, a method for producing a photovoltaic label is described. The method comprises at least the following steps, preferably in the indicated order: providing a sub-stack including a first lamination foil, a second lamination foil and a solar cell arrangement comprising multiple wafer-based solar cells, the solar cell arrangement being interposed between the first and second lamination foils,
providing an elongate flexible carrier sheet having a length of at least 2 m,
forming an overall-stack by attaching the sub-stack to the carrier sheet, and
bending the overall-stack into a roll configuration.

According to a second aspect of the invention, a photovoltaic label is described. The PV label comprises at least the following components:
a sub-stack including a first lamination foil, a second lamination foil and a solar cell arrangement comprising multiple wafer-based solar cells, the solar cell arrangement being interposed between the first and second lamination foils,
an elongate flexible carrier sheet having a length of at least 2 m,
wherein the sub-stack is attached to the carrier sheet thereby forming an overall-stack, and
wherein the overall-stack is bent into a roll configuration.

Briefly summarised and without limiting the scope of the invention, basic ideas underlying embodiments of the invention and associated possible advantages will be roughly described as follows:
As indicated above, PV labels may be used for fabricating PV panels having a large size and/or having a curved geometry. For example, it may be intended to cover an entire surface of a cargo box for a reefer of several meters in length with a PV label. It has been found that handling a large PV label during a fabrication process may be troublesome. Particularly, handling a large sized PV label being in a planar configuration may be difficult in an industrial PV panel fabrication environment. It is therefore suggested herein to produce a PV label in which at least a carrier sheet has a very substantial size, particularly a length of several meters. Therein, an overall-stack is formed by attaching a sub-stack to the carrier sheet, the sub-stack including a solar cell arrangement interposed between opposing first and second lamination foils. Having a large length, the overall-stack may then be bent into a roll configuration. In such a roll configuration, the sheet-like and bendable PV label is arranged in a wound, quasi-cylindrical shape and may therefore be provided in a space saving manner and may be easily transported and handled. It has surprisingly been found that, although wafer-based solar cells are generally very brittle and should not be submitted to excessive mechanical stress, a PV label including such wafer-based solar cells may be bent into the roll configuration in cases where the solar cells are sufficiently supported and protected against excessive bending due to being connected to the carrier sheet and/or some stabilisation foil. Furthermore, having a length of more than at least 2 m, the PV label may be bent into the roll configuration with a sufficiently large curvature radius, thereby preventing excessively bending the PV cells comprised therein. The rolled PV label may then be unrolled from its roll configuration e.g. in roll-to-roll processes or roll-to-sheet processes used for fabricating large sized and/or curved PV panels.

In the following, possible features of embodiments of the invention and associated possible advantages will be described in more detail.

The approach proposed herein is particularly suitable for PV labels comprising multiple PV cells which are prepared based on brittle semiconductor wafers. The PV cells may be for example solar cells being fabricated based on crystalline silicon wafers. Such wafer-based Si-PV cells may generally have e.g. a high efficiency of more than 15% (i.e. e.g. between 17% and 26%) and a high reliability. Furthermore, well established industrial processes exist for their fabrication. Such PV cells typically have lateral dimensions of between 50x50 mm² and 300x300 mm², mostly between 150x150 mm² and 200x200 mm², with a square shape, a rectangular shape, a round shape, a semi-round shape or any other shape. Furthermore, such PV cells generally have a thickness of more than 50 µm, typically between 100 µm and 300 µm.

Having such thickness, the PV cells are relatively rigid, i.e. they may generally not be bent into small bending radii of e.g. less than their lateral dimensions. Generally, it may be assumed that, depending on a cell size, bending radii of less than 60 cm, less than 80 cm, less than 90 cm or less than 100 cm should be avoided.

Each PV cell comprises electric contacts. The electric contacts of neighbouring PV cells may be interconnected via electrical connections such that these PV cells may be electrically connected in series, in parallel or in any combination of series and parallel connections. The electrical connections may be provided by one or more electrically conducting ribbons and/or one or more copper solderings between two adjacent photovoltaic cells. A plurality of interconnected PV cells forms part of a solar cell arrangement, sometimes also referred to as solar cell string. Furthermore, the solar cell arrangement may comprise additional components such as external contacts via which the solar cell arrangement may be connected to an external electric circuit, such external contacts sometimes being referred to as forming part of a junction box. Additionally, the solar cell arrangement may comprise for example bypass diodes or other electric components. Optionally, one or more release loops for releasing mechanical tensions may be included in the solar cell arrangement.

The solar cell arrangement is generally comprised in an encapsulation into which the solar cells, the electrical interconnections and possibly other components are embedded. Therein, a sub-stack is formed with the solar cell arrangement being interposed between opposing lamination foils. Typically, the encapsulation comprises or consists of a thermoplastic polymer such as thermoplastic polyurethane or thermoplastic polyolefin or thermosetting elastomers such as EVA (Ethylene Vinyl Acetate) or POE (Polyolefin Elastomer). The encapsulation may be composed of a first lamination foil (which may also be referred to as front side polymeric lamination foil) and a second lamination foil (which may also be referred to as rear side polymeric lamination foil) enclosing the plurality of solar cells from opposite sides. The lamination foils may also be referred to as encapsulation foils. In a lamination procedure, such front and rear side encapsulation foils may then be heated beyond a glassifying temperature of the polymeric material while being pressed against each other. Accordingly, the sticky viscous or even partially molten polymer material of both encapsulation foils may combine in regions where the foils contact each other and/or may glue to solar cells interposed between the encapsulation foils. Accordingly, upon cooling down and solidifying the polymer material, the solar cells and the polymer material of the lamination foils may form an encapsulation.

As the solar cell arrangement in its encapsulation is generally very fragile, the solar cell arrangement including the solar cells and the electric connections together with the encapsulation may be reinforced by one or more other sheets or foils for forming a PV label. Preferably, the carrier sheet and, optionally, one or more polymeric stabilisation foils used for such reinforcement may be attached to the solar cell arrangement and/or may enclose the interposed solar cell arrangement and may form a mechanically stabilising substrate and/or a mechanically stabilising superstrate, respectively, for the solar cell arrangement comprised in the sub-stack.

Therein, the carrier sheet may be made from a material and may be provided with a geometry such as to, on the one hand, enable a sufficient flexibility and bendability while, on the other hand, sufficiently supporting and stabilising the sub-stack including the solar cell arrangement against e.g. excessive bending thereof.

For example, the carrier sheet may be provided as a thin sheet of glass, metal or plastics or a compound thereof. The carrier sheet generally has a thickness being larger than a thickness of each of the lamination foils and possibly being even larger than a thickness of the entire sub-stack. For example, the carrier sheet may have a thickness of more than 10 µm or more than 50 µm, preferably more than 100 µm, more than 200 µm, more than 500 µm, or even more than 1 mm. Due to such large thickness, the carrier sheet may provide a stabilising function to the sub-stack. However, the thickness of the carrier sheet should generally be less than 10 mm, preferably less than 5 mm, less than 3 mm or even less than 2 mm. The carrier sheet should be reversibly bendable, i.e. deformable without cracking or irreversibly changing its structure, to a curvature radius of less than 2 m, preferably less than 1 m or even less than 0.6 m.

The carrier sheet has lateral dimensions which are significantly larger than the dimensions of a conventional PV panel. Particularly, the length of the carrier sheet is at least 2 m, preferably at least 3 m, at least 5 m or even at least 10 m. A width of the carrier sheet may depend on dimensions in a specific application in which the PV label is to be used. For example, such width may be larger than 30 cm, larger than 50 cm or even larger than 1 m or larger than 2.5 m. Preferably, the width is smaller than 10 m, smaller than 6 m or even smaller than 4 m. Accordingly, an area of the PV label may be larger than 2 m², preferably larger than 5 m² or even larger than 10 m².

The overall-stack is formed by attaching the sub-stack to the carrier sheet. Preferably, the sub-stack and the carrier sheet are joined with each other along their entire interface. As discussed further below, various options for attaching the sub-stack to the carrier sheet may be applied.

After having formed the overall-stack in such way, the overall-stack may be bent into the roll configuration. Therein, a bending action should be applied such that the overall-stack is bent homogeneously, i.e. with a substantial same radius along its entire bended surface. The overall-stack may be bent into at least one entire winding, preferably into multiple windings, such that opposing end portions of the overall-stack overlap each other and the rolled overall-stack may be handled as a stable, substantially cylindrical unit.

In order to then produce for example a PV panel using the PV label, the PV label may be unrolled from its rolled configuration and may then for example be joined to a planar or slightly curved supporting substrate.

The entire PV label may have a thickness in a range of between 0.5 mm to 10 mm, typically between 0.5 mm to 5 mm or between 1 mm and 3 mm. Lateral dimensions, i.e. a width, of the PV label may range from about 0.3 m to 10 m, typically from 0.5 m to 3 m. The PV label may be flexible and bendable and may be wound e.g. into the roll configuration in which the PV label is arranged in a cylindrical or quasi-cylindrical configuration. Therein, a bending radius may be adapted to a rigidity and/or bendability of the solar cells included in the PV label such as to reliably avoid any cell breakage. The solar cells comprised in the PV label cover a substantial portion, i.e. for example more than 30%, preferably more than 50%, more than 70% or even more than 90%, of an entire area of the PV label.

According to an embodiment, the sub-stack may further include a first stabilisation foil and/or a second stabilisation foil. Therein, the first stabilisation foil may be attached to one of the first and second lamination foils and/or the second stabilisation foil may be attached to the other one of the first and second lamination foils.

The one or more stabilisation foils may have a thickness of typically between 100 µm and 5 mm, preferably between 0.25 mm and 2.5 mm. Each of the stabilisation foils may adjoin and/or cover a part or an entirety of one of opposing surfaces of all of the PV cells. The stabilisation foils may be made with various polymeric materials such as, polycarbonate (PC), polyethylenterephthalat (PET), polyamide (PA), polyetheretherketone (PEEK), Acrylonitrile butadiene styrene (ABS), Polymethyl methacrylate) (PMMA), Polyvinylchlorid (PVC) or a mix of them. At least the front side stabilisation foil as well as the front side lamination foil shall consist of an optically translucent or transparent material. Particularly, a material forming the stabilisation foil may be a thermoplastic material, i.e. a material which becomes plastic or viscous upon being heated to elevated temperatures. The front and rear side polymeric stabilisation foils may enclose the interposed solar cell arrangement and, upon being joined with each other, encapsulate the solar cell arrangement. Optionally, glass fiber reinforced or carbon fiber reinforced plastics may be included in or between the polymeric foils.

According to an embodiment, at least one of the carrier sheet and the optional first and second stabilisation foils have a bending stiffness being higher than a bending stiffness of each of the first and second lamination foils.

Thus, the carrier sheet and/or one or more of the stabilisation foils may stabilise the solar cell arrangement interposed between the lamination foils and thereby prevent excessive bending thereof e.g. during a bending process for bringing the PV label into the roll configuration. The higher bending stiffness of the carrier sheet and/or the stabilisation foil(s) as compared to the lamination foils may result from the carrier sheet and/or stabilisation foil(s) having a larger thickness and/or being made with a mechanically more stable material than the lamination foils.

According to an embodiment, the overall-stack is bent into the roll configuration by winding the overall-stack onto a cylindrical spool.

In other words, upon having formed the overall-stack by joining the sub-stack to the carrier sheet, a cylindrical spool may be provided and the sheet-like overall-stack may be adjoined to the spool and may successively be wound onto the spool. For example, a quasi-continuous process may be established in which a portion of the overall-stack is formed and is then wound onto the spool. In such process, the spool may be rotated and the overall-stack may be continuously or in a step-like manner supplied to the spool. The spool may define an inner geometry and, particularly, an inner radius of the roll configuration into which the PV label is wound.

According to an embodiment, the roll configuration has an inner diameter of at least 0.6 m.

The inner diameter of the roll configuration may be set such that none of the brittle solar cells is excessively bent upon bending the overall-stack into the roll configuration. For such purpose, the minimum inner diameter of the roll configuration should be at least 0.6 m, preferably at least 0.7 m, at least 0. 8 m, at least 0.9 m or even at least 1 m. Therein, half of such minimum inner diameter generally corresponds to a curvature radius to which the solar cells are bent. Thus, a risk of solar cell breakage may be minimised.

According to an embodiment, the carrier sheet is continuously provided by unrolling the carrier sheet from a roll configuration.

In other words, before being attached to the sub-stack, the carrier sheet itself may be provided in a rolled configuration, from which it may then be unrolled in order to apply and join it with the sub-stack. Accordingly, the carrier sheet may be provided in a space-saving manner.

According to an embodiment, the overall-stack is formed by stacking multiple components including at least a portion of the lamination foils of the sub-stack, at least a portion of the optional stabilisation foils of the sub-stack, at least a portion of the solar cell arrangement of the sub-stack and a portion of the carrier sheet together into a laminator device and laminating all components together.

For example, respective portions of the carrier sheet and of the optional first stabilisation foil and/or second stabilisation foil may be joined together with the solar cell arrangement and its encapsulating lamination foils by an application of heat and pressure in a lamination process. In other words, after having stacked a partial area of the carrier sheet together with e.g. the rear side polymeric stabilisation foil, the solar cell arrangement with its encapsulation and finally the front side polymeric stabilisation foil on top of each other in a lose manner, these stacked layers may be interconnected by mechanically joining them with each other. Such joining may be induced for example by applying sufficient heat to the stack such that the polymeric material of the foils becomes viscous and/or sticky. Accordingly, upon such temporary application of heat, the polymeric stabilisation foils may mechanically interconnect with each other and/or with the interposed solar cell arrangement.

Thus, the front and rear side polymeric stabilisation foils and the solar cell arrangement included in its encapsulation of lamination foils may be joined in a lamination procedure, thereby laminating the sub-stack. Additionally, also the carrier sheet is included in such laminate, thereby integrally forming the overall-stack. The lamination procedure is integral with the lamination procedure used for forming the encapsulation embedding the PV cells, i.e. both the front and rear side polymeric stabilisation foils as well as the front and rear side polymeric lamination foils may be glassified and/or partially molten within a single lamination step. Alternatively, two separate lamination steps may be performed, i.e., first, the solar cell arrangement is laminated with the encapsulation foils enclosing the PV cells and, then, the overall-stack of the PV label is laminated with the carrier sheet and, optionally, e.g. two stabilisation foils enclosing the solar cell arrangement in between. As a result of such lamination procedure, the carrier sheet, the first and second polymeric lamination foils, the optional stabilisation foils and, optionally, also the PV cells are integrally joined with each other in a positive substance jointing. However, the lamination procedure may alternatively or additionally include other measures for joining the polymeric foils such as for example applying a glue or adherent at an interface between the polymeric foils and/or at an interface between one of the polymeric foils and the solar cell arrangement.

According to a further specified embodiment, at least one of the lamination foils and the optional stabilisation foils has a length of at least 2 m and is continuously provided by unrolling it from a roll configuration.

In other words, not only the carrier sheet also at least one of the lamination foils and/or of the stabilisation foils has a length being substantially longer than a typical length of a single conventional PV panel. For example, such length may be more than 2 m, preferably more than 3 m, more than 5 m or even more than 10 m. Accordingly, with such long lamination foils and/or stabilisation foils, the overall-stack may be formed with not only the carrier sheet being continuous over a significant length but also the lamination foils and/or stabilisation foils continuously extending along such significant length. Therein, the lamination foils and/or stabilisation foils may be provided in a roll configuration from which they may be unrolled before stacking the sub-stack. Accordingly, the entire process of stacking and forming the overall-stack may be established in a roll-to-roll fashion and may be implemented in a space saving manner.

According to an embodiment, the solar cell arrangement comprises multiple solar cell strings, each solar cell string including several of the wafer-based solar cells electrically interconnected with each other. Therein, at least one of the solar cell strings is arranged between portions of the first and second lamination foils before then laminating all components together.

Expressed differently, the solar cells in the solar cell arrangement are arranged in strings of solar cells wherein multiple solar cells are electrically interconnected in series and/or in parallel. Such strings may be prefabricated for example by soldering connectors to busbars provided at each of the solar cells for interconnecting these solar cells. One or more of such prefabricated solar cell strings may then be arranged between portions of the first and second lamination foils. As these lamination foils may be provided with a substantial length and may be e.g. unrolled from a roll configuration, the solar cell strings generally only cover a portion of such lamination foils. Accordingly, for forming the overall-stack, portions of the carrier sheet, the lamination foils and, optionally, the stabilisation foils may for example be unrolled and stacked on top of each other and one or a few solar cell strings may be interposed between the portions of the lamination foils. Having arranged such stack, all of its components may then be laminated in a common lamination step. Accordingly, forming the overall-stack along its entire length of at least 2 m may be established by successively performing several lamination procedures at various neighbouring portions of the overall-stack. In order to reduce the stress on the cells and allow for a smaller bending radius, solar cells may be cut to ½, ¼, 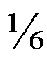 . And interconnection technologies such as conductive backsheet and electric conductive adhesives, which do not put too much pressure on the edge of the cells, may help to reduce the rolling radius.

According to an alternative embodiment, the sub-stack may be provided as a preassembled entity. In such case, the overall-stack may be formed by adhering the sub-stack to the carrier sheet.

In other words, the sub-stack may be formed in a separate, preceding fabrication process and may be provided within the method proposed herein as the preassembled entity. Therein, the lamination foils and, optionally, the stabilisation foils may already be joined with each other to form a common laminate. Such sub-stack laminate may then be adhered to the carrier sheet, thereby forming the overall-stack. Such adhering may be established using lamination techniques, i.e. application of heat and pressure. Alternatively, the sub-stack may be glued or adhered in another way to the carrier sheet.

Therein, according to a further specified embodiment, the preassembled entity may have a length being substantially smaller than the length of the carrier sheet.

Accordingly, multiple of the preassembled shorter sub-stacks may be provided and may be attached to a single longer carrier sheet. The carrier sheet therefore interconnects the sub-stacks such that, due to the substantial length of the carrier sheet, the resulting overall-stack may be wound into the roll configuration.

It shall be noted that possible features and advantages of embodiments of the invention are described herein partly with respect to a method of producing a PV label and partly with respect to a PV label producible with such method. One skilled in the art will recognize that the features may be suitably transferred from one embodiment to another and features may be modified, adapted, combined and/or replaced, etc. in order to come to further embodiments of the invention.

### BRIEF DESCRIPTION OF THE DRAWINGS

In the following, advantageous embodiments of the invention will be described with reference to the enclosed drawings. However, neither the drawings nor the description shall be interpreted as limiting the invention.
Fig. 1 shows an arrangement suitable for producing a photovoltaic label in accordance with an embodiment of the present invention.
Fig. 2 shows a sectional view of a portion of a photovoltaic label in accordance with an embodiment of the present invention.
Fig. 3 shows an alternative arrangement suitable for producing a photovoltaic label in accordance with an embodiment of the present invention.

The figures are only schematic and not to scale. Same reference signs refer to same or similar features.

### DESCRIPTION OF PREFERRED EMBODIMENTS

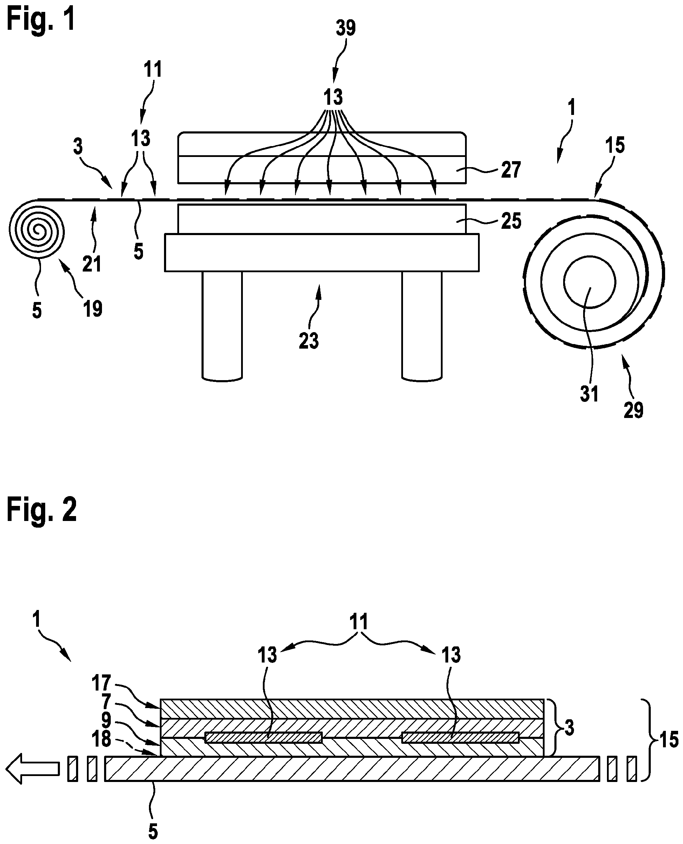

Fig. 1 shows an arrangement with which a photovoltaic label 1 may be produced. Fig. 2 shows a sectional view of a portion of such PV label 1.

In the proposed method for producing the PV label 1, a sub-stack 3 and an elongate flexible carrier sheet 5 are provided. The sub-stack of 3 at least comprises a first lamination foil 7, a second lamination foil 9 and a solar cell arrangement 11. The solar cell arrangement 11 comprises multiple wafer-based solar cells 13 interconnected in series and/or in parallel to form one or more solar cell strings 39. The solar cell arrangement 11 is interposed between the first and second lamination foils 7, 9, with the first lamination foil 7 covering a front side of the solar cells 13 and the second lamination foil 9 covering a rear side of the solar cells 13.

In the example shown in Figs. 1 and 2, the sub-stack 3 further comprises a first stabilisation foil 17 arranged at a front side of the first lamination foil 7, thereby serving as a front side stabilisation foil. In an alternative embodiment (not shown, but indicated with a dotted arrow), an additional second stabilisation foil 18 could be arranged at a rear side of the second lamination foil 9, thereby serving as a rear side stabilisation foil. The stabilisation foil(s) 17, 18 may be mechanically more stable and/or more rigid than the lamination foils 7, 9 and may therefore have a higher bending stiffness, which may be due to having a larger thickness and/or being made of a more stable material.

In the approach visualised in Figs. 1 and 2, the elongate flexible carrier sheet 5 is a continuous layer of polymer material having a length of e.g. 10 m or more. The carrier sheet 5 is initially provided in a roll configuration 19. For fabricating the PV label 1, the carrier sheet 5 is unrolled from such roll configuration 19 and is brought into a planar configuration 21. On top of the carrier sheet 5 in its planar configuration 21, the second lamination foil 9 is disposed, then one or more solar cell strings 39 of the solar cell arrangement 11 is arranged on top of the second lamination foil 9 and is then covered by the first lamination foil 7 and, in the end, the first stabilisation foil 17 is arranged on top of the first lamination foil 7. Thereby, the sub-stack 3 is formed.

This sub-stack 3 may have lateral dimensions corresponding to the dimensions of an inner volume of a laminator device 23. Accordingly, after having arranged the sub-stack 3 on top of the continuous carrier sheet 5, the entire stack comprising the sub-stack 3 and the carrier sheet 5 may be moved into the laminator device 23. Therein, it may be pressed between a lower plate 25 and an upper plate 27 of the laminator device 23. At the same time, it may be heated to elevated temperatures. As a result of such procedure, the polymer material in the lamination foils 7, 9 and the stabilisation foil(s) 17, 18 as well as possibly the polymer material in the carrier sheet 5 temporarily becomes viscous or even partially molten and, upon resolidification, the sub-stack 3 is attached to the carrier sheet 5 in a laminate, thereby forming the overall-stack 15.

After having been released from the laminator device 23, the overall-stack 15 is then bent into a roll configuration 29 by winding it onto a cylindrical spool 31. Therein, the spool 31 has a diameter of approximately 0.8 m or more, such that even in its roll configuration 29, the overall-stack 15 is not bent into an excessively small radius of curvature, thereby avoiding any damage to the solar cells 13 comprised therein.

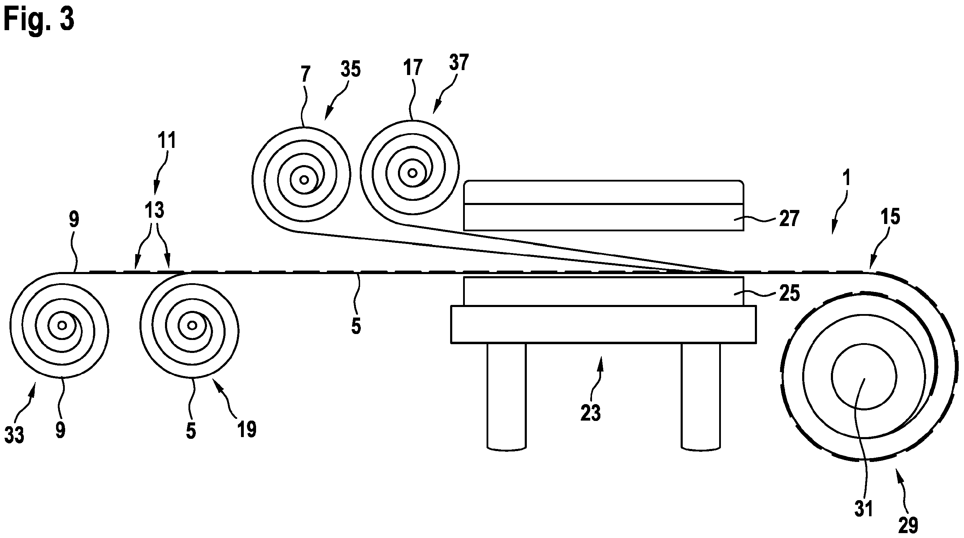

In an alternative embodiment, as shown in Fig. 3, instead of providing the foils 7, 9, 17 comprised in the sub-stack 3 as separate sheets, each having dimensions similar to the dimensions in the inner volume of the laminator 3, these lamination foils 7, 9 and stabilisation foils 17 are supplied in a continuous manner. For such purpose, not only the carrier sheet 5 is provided in a roll configuration 19 and is then unrolled before entering the laminator device 23, but also the rear side second lamination foil 9 is provided in a roll configuration 33, the front side first lamination foil 7 is provided in a roll configuration 35 and the stabilisation foil 17 is provided in a roll configuration 37.

Accordingly, except for the solar cells 13 in the solar cell arrangement 11, all components comprised in the sub-stack 3 including the lamination foils 7, 9 and the stabilisation foil(s) 17, 18 as well as the carrier sheet 5 may be provided in a continuous manner before being laminated together in the laminator device 23 for forming the overall-stack 15. After the lamination process, the overall-stack 15 may then again be bent into the roll configuration 29 by winding it onto the spool 31.

In another alternative embodiment (not shown in the figures), the sub-stack 3 is provided as a pre-assembled entity. In other words, prefabricated semi-flexible PV module sheets enclosing the solar cell arrangement 11 with its solar cells 13 may be provided and may then be placed on top of a carrier sheet 5 having a length which is substantially longer than the length of the sub-stack 3. Subsequently, the portion of the carrier sheet 5 covered by such preassembled sub-stack 3 entity is fed into the laminator device 23, thereby laminating together both components and forming the overall-stack 15.

As an alternative to such lamination procedure, the preassembled sub-stack 3 entity may be attached to the carrier sheet 5 using other techniques such as gluing. Accordingly, the use of a laminator device 23 for this embodiment of the method is not necessary as long as a complete adhesion between the sub-stack 3 and the supporting carrier sheet 5 is ensured. Finally, the resulting overall-stack 15 may again be wound into the roll configuration 29.

It may be noted that, beside the main components of the PV label 1, i.e. the solar cells 13 and their electrical interconnections in the solar cell arrangement 11, the lamination foils 7, 9 forming the encapsulant and, optionally, the front and/or rear side stabilisation foil(s) 17, 18, other functional layers may also be added to the overall-stack 15 forming the PV label 1 through e.g. the above mentioned methods. For instance, reinforcement layers made of glass fibre, gas or humidity barrier layers, extra layers of encapsulant, design elements, etc. could be added to the stack, whether in a sheet format or a roll format.

Finally, it should be noted that the term "comprising" does not exclude other elements or steps and the "a" or "an" does not exclude a plurality. Also elements described in association with different embodiments may be combined. It should also be noted that reference signs in the claims should not be construed as limiting the scope of the claims.

### LIST OF REFERENCE SIGNS

- 1: PV label
- 3: sub-stack
- 5: carrier sheet
- 7: first lamination foil
- 9: second lamination foil
- 11: solar cell arrangement
- 13: solar cells
- 15: overall-stack
- 17: first stabilisation foil
- 18: second stabilisation foil
- 19: roll configuration
- 21: planar configuration
- 23: laminator device
- 25: lower plate
- 27: upper plate
- 29: roll configuration
- 31: spool
- 33: roll configuration
- 35: roll configuration
- 37: roll configuration
- 39: solar cell string

## Claims

1. Method for producing a photovoltaic label (1), the method comprising:
providing a sub-stack (3) including a first lamination foil (7), a second lamination foil (9) and a solar cell arrangement (11) comprising multiple wafer-based solar cells (13), the solar cell arrangement (11) being interposed between the first and second lamination foils (7, 9),
providing an elongate flexible carrier sheet (5) having a length of at least 2 m,
forming an overall-stack (15) by attaching the sub-stack (3) to the carrier sheet (5), and
bending the overall-stack (15) into a roll configuration (29).

2. Method according to claim 1,
wherein the sub-stack (3) further includes at least one of a first stabilisation foil (17) and a second stabilisation foil (18), with at least one of the first stabilisation foil (17) being attached to one of the first and second lamination foils (7, 9) and the second stabilisation foil (18) being attached to the other one of the first and second lamination foils (7, 9).

3. Method according to one of the preceding claims,
wherein at least one of the carrier sheet (5) and the optional first and second stabilisation foils (17, 18) have a bending stiffness being higher than a bending stiffness of each of the first and second lamination foils (7, 9).

4. Method according to one of the preceding claims,
wherein the overall-stack (15) is bent into the roll configuration (29) by winding the overall-stack (15) onto a cylindrical spool (31).

5. Method according to one of the preceding claims,
wherein the roll configuration (29) has an inner diameter of at least 0.6 m.

6. Method according to one of the preceding claims,
wherein the carrier sheet (5) is continuously provided by unrolling the carrier sheet (5) from a roll configuration (19).

7. Method according to one of the preceding claims,
wherein the overall-stack (15) is formed by stacking multiple components including at least a portion of the lamination foils (7, 9) of the sub-stack (3), at least a portion of the optional stabilisation foils (17, 18) of the sub-stack (3), at least a portion of the solar cell arrangement (11) of the sub-stack (3) and a portion of the carrier sheet (5) together into a laminator device (23) and laminating all components together.

8. Method according to claim 7,
wherein at least one of the lamination foils (7, 9) and the optional stabilisation foils (17, 18) has a length of at least 2 m and is continuously provided by unrolling it from a roll configuration (33, 35, 37).

9. Method according to one of the claims 7 and 8,
wherein the solar cell arrangement (11) comprises multiple solar cell strings (39), each solar cell string (39) including several of the wafer-based solar cells (13) electrically interconnected with each other,
wherein at least one of the solar cell strings (39) is arranged between portions of the first and second lamination foils (7, 9) before then laminating all components together.

10. Method according to one of the claims 1 to 6,
wherein the sub-stack (3) is provided as a preassembled entity, and
wherein the overall-stack (15 is formed by adhering the sub-stack (3) to the carrier sheet (5).

11. Method according to claim 10,
wherein the preassembled entity has a length being substantially smaller than the length of the carrier sheet (5).

12. Photovoltaic label (1) comprising:
a sub-stack (3) including a first lamination foil (7), a second lamination foil (9) and a solar cell arrangement (11) comprising multiple wafer-based solar cells (13), the solar cell arrangement (13) being interposed between the first and second lamination foils (7, 9), an elongate flexible carrier sheet (5) having a length of at least 2 m,
wherein the sub-stack (3) is attached to the carrier sheet (5) thereby forming an overall-stack (15), and
wherein the overall-stack (15) is bent into a roll configuration (29).
